# EUROPEAN PATENT APPLICATION

(11) **EP 4 509 846 A1**
(43) Date of publication of application: **19.02.2025**
(21) Application number: 23788683.3
(22) Date of filing: 27.03.2023
(51) Int. Cl.: G01R 31/08

(54) **DEVICE FOR MONITORING THE STATE OF AN ELECTRIC POWER TRANSMISSION LINE**

(30) Priority: 15.04.2022 RU 2022110227
(71) Applicant: Obschestvo S Ogranichennoi Otvetstvennostyu "system", Ekaterinburg 620072 (RU)
(72) Inventor: STOROZHEVA, Polina Evgenevna, Tagil, 622049 (RU)
(74) Representative: Spengler, Robert
(86) International application number: PCT/RU2023/050063
(87) International publication number: WO 2023/200371

(57) **Abstract**

The invention relates to autonomous satellite data transmission devices and can be applied to obtain data on the condition of power transmission lines located at remote and inaccessible locations, and can be used in the power industry. The essence of the invention lies in the power transmission line condition monitoring device wherein the transceiver provides two-way communication via low-orbit satellite repeaters at frequencies from 300 to 450 MHz, and the antenna provides a horizontal radiation pattern width of 360°. Technical result aimed at achievement of which the invention is directed, consists in increase of stability of signal stability of two-way communication of the transceiver with repeaters of low-orbit satellites.

## Description

The Invention is related to autonomous satellite data transmission devices and can be applied to obtain data on the condition of power lines located in remote and hard-to-reach locations, and can be used in the energy industry.

The power transmission line condition monitoring device containing a means of attachment to the power transmission line, electrically connected: a power supply, a module of wireless communication consisting of a transceiver and an antenna, a control controller, and a sensor of the electromagnetic field strength around the power transmission line is selected as a prototype, the transceiver provides two-way communication via low-orbit satellite repeaters at frequencies from 450 to 470 MHz, and the antenna is made parabolic and provided with a drive [US2004056771, date of publication: 25.03.2004, IPC: G0IN 27/00; G08B 21/14; G08B 21/16].

The disadvantage of the prototype is the unstable signal and, accordingly, the speed of data exchange between the device for power transmission line condition monitoring and the remote server of the monitoring centre under adverse weather conditions and high terrain drops, due to the frequency range at which the wireless communication module carries out two-way communication via low-orbit satellite repeaters, as a result of which there is a possible loss of control over the device itself, as well as loss of packets with data transmitted by the electromagnetic field strength sensor, which significantly increases the risk of untimely notification of the monitoring centre operator about the occurrence of a fault on the power transmission line and significantly worsens the performance characteristics of the power transmission line condition monitoring device.

The technical problem to which the invention is directed is the need to improve the performance characteristics of the power transmission line condition monitoring device.

Technical result aimed at achievement of which the invention is directed, consists in increase of stability of signal stability of two-way communication of the transceiver with repeaters of low-orbit satellites.

The essence of the invention is as follows.

The device for the power transmission line condition monitoring device a means for mounting on the power transmission line, electrically connected: a power supply, a wireless communication module consisting of a transceiver and an antenna and providing two-way communication via low-orbit satellite repeaters, a control controller and an interface for connecting a power transmission line condition monitoring device. In contrast to the prototype, the transceiver provides two-way communication via low-orbit satellite repeaters at frequencies from 300 to 450 MHz, and the antenna provides a 360° horizontal radiation pattern width.

The power transmission line (PTL) condition monitoring device provides the possibility of receiving various kinds of information from the power lines remote from the municipal centres and its transmission using a low-orbit satellite transponder.

The means of attachment to the power transmission line provides the possibility of fixing the device to the elements of the PTL structure and may be represented by a bracket, a crimping element, a spacer, etc. The fixation means may be fixed to the device body, or conversely, the individual components of the device may be fixed to the fixation means.

The power source is connected to the controller and can be represented as a renewable energy source that can utilise solar, water or wind power depending on the location of the docking station. This device can be represented as an element interacting with a source of renewable energy, and an element converting the energy received from the source into electrical energy. The device may for example be in the form of a paddle or paddlewheel and a generator, or in the form of a photovoltaic panel. Alternatively the power transmission line may be represented as a power source. To connect to it, the device can be equipped with a specialized interface. Alternatively the rechargeable battery may be represented as a power source.

Preferably, in the most preferred embodiment providing a permanently high stability of the two-way communication signal with low-orbit satellite repeaters provided by the wireless communication module, the power supply may be in the form of a supercapacitor having low degradation and low dependence on the environment. In this case additionally the supercapacitor can be provided with a charge controller providing possibility of redistribution of electric energy of the supercapacitor to consumers of electric energy of the device, that also increases stability of two-way communication with repeaters of low-orbit satellites.

The controller converts the data received from the interface for connecting the power transmission line status sensor into a digital signal, which uses the required amount of electrical energy from the power source. Data conversion by the controller is provided by pulse-code modulation. The most common types of modulation are phase manipulation and quadrature amplitude modulation.

The interface for connection of the power transmission line status sensor provides the possibility of electrical connection of the sensor with the controller. The interface can be located on the housing or inside the housing of the device and can be in the form of an interface board, a socket, an electrical connector with a wire and so on. The USART and/or USB interface may be used to ensure the versatility of the device.

The power transmission line condition sensor provides the possibility of obtaining data on the technical condition of the PTL, including the value of the electromagnetic field strength around the PTL, the spatial position of the PTL elements, climatic conditions around the PTL, etc. The sensor can be made removable or non-removable, for which the interface can have a suitable design.

The WLAN module consists of a transceiver and an antenna connected to it. The transceiver is connected to the controller and provides two-way communication via low-orbit satellite transponders at frequencies from 300 to 450 MHz to transmit data from the PTL status sensor and receive control signals. The specified range ensures increased stability of the transceiver's two-way communication signal with low-orbit satellite repeaters under unfavourable weather conditions, including heavy snowfall or rain and high terrain drops, interference from tree branches. At the same time frequency exceeding the lower or upper limit of the range entails short-term signal loss under unfavourable weather conditions and high terrain variations, worsening its stability. Additionally in order to improve the stability of the two-way communication signal of the transceiver with low-orbit satellite repeaters, the data rate may be limited to a range of 100 to 50,000 bytes per hour.

The antenna provides a 360° width of the horizontal directivity diagram that increases the stability of the two-way communication signal of the transceiver with the transponders of low-orbit satellites at any spatial position relative to the device, and also provides a stable two-way communication signal of the transceiver with their repeaters. This function can be provided by the design features of the antenna, which for this purpose can be made spiral or in the form of a planar array. The antenna can be located inside or outside the enclosure or can be mounted on the same board as the transceiver.

The device can comprise a housing, inside or outside of which the components of the device can be mounted. The enclosure can be made moisture-proof and have elements for mounting the data source represented by cutouts, recesses or recesses, which are arranged in such a way that, when the data source is mounted, reliable contact with the electrical connection means is ensured.

The electrical connection of the components of the device to each other is predominantly in the form of wires or cables or contact tracks in the case of mounting the components on a printed circuit board, or may be in the form of wires or cables in the case of separate mounting of the components.

The invention can be made from known materials by known means, which shows that it fulfils the patentability criterion "industrial applicability".

The invention is described by a set of essential features previously unknown in the art, characterised by the fact that the transceiver provides two-way communication via low-orbit satellite repeaters at frequencies from 300 to 450 MHz, the antenna provides a 360° width of the horizontal radiation pattern, which together allows to exchange data with low-orbit satellite repeaters under unfavourable weather conditions, including heavy snowfall or rain and high terrain drops, interference from tree branches, as well as at any position of a low-orbit satellite relative to the device.

Due to this the achievement of technical result is provided, consisting in increasing the stability of the two-way communication signal of the transceiver with low-orbit satellite repeaters, thereby improving the performance characteristics of the device for the power transmission line condition monitoring device.

The invention possesses a previously unknown set of essential features from the prior art, which indicates its compliance with the patentability criterion "novelty".

The device for the power transmission line condition monitoring device is known from the prior art, the transceiver of which provides two-way communication via low-orbit satellite repeaters at the frequencies from 450 to 470 MHz.

However, there is no prior art device for the power transmission line condition monitoring device wherein the transceiver simultaneously provides two-way communication via low-orbit satellite repeaters at frequencies from 300 to 450 MHz, and the antenna provides a 360° horizontal radiation pattern width. This design of the wireless communication module provides a stable two-way communication signal of the transceiver with transponders of low-orbit satellites when the device is installed in hard-to-reach and remote from regional centres in any weather conditions and at high terrain differences, interference from tree branches. In view of this, the invention fulfils the patentability criterion "inventive step".

The invention is explained by the following figures.

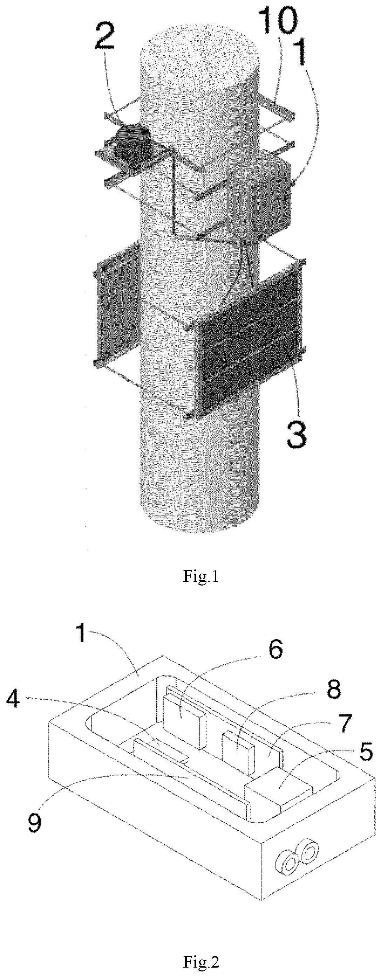

Fig. 1 - The power transmission line condition monitoring device fixed on a support, isometric.
Fig.2 - Components of the power transmission line condition monitoring device located inside the housing, isometric.

In order to illustrate the feasibility and to better understand the invention, an embodiment of the invention is presented below, which may be modified or supplemented in any way, the present invention being in no way limited to the embodiment presented.

The power transmission line condition monitoring device contains a housing 1 and a cylindrical spiral antenna 2, providing a horizontal directivity diagram width of 360°. In this case, photovoltaic panels 3 are arranged on the outside of the housing 1.

Inside the case 1 are fixed: controller 4 control, supercapacitor 5 with controller 6 charge, interface board 7 with mounted on it sensor 8 electromagnetic field strength around the transmission line and wireless communication module containing transceiver 9, providing two-way communication via low-orbit satellite repeaters at frequencies from 300 to 450 MHz and data transmission at a rate of 100 to 50,000 bytes per hour.

The photovoltaic panel 3 is connected to the supercapacitor charge controller 6; the supercapacitor charge controller 6 is connected to the supercapacitor 5 with the capability of transmitting and receiving electrical energy; connected to the control controller 4 with the capability of exchanging data; connected to the control controller 4 with the capability of transmitting electrical energy.

The control controller 4 is connected to the interface board 7 with data communication capability; connected to the interface board 7 with electrical power transmission capability.

The interface board 7 is arranged to transmit electrical energy to a sensor 8 of electromagnetic field strength around the transmission line; arranged to receive data from the sensor 8.

The transceiver 9 is connected to the control controller 4 for communicating data; connected to the control controller 4 for receiving electrical power; and connected to the antenna 2 for transmitting and receiving an electrical signal.

The housing 1, the antenna 2 and the photovoltaic panels 3 are fixed to the power line support by means of a bracket 10.

The invention works as follows.

The electromagnetic field strength sensor 8 around the power line receives power from the interface board 7 and transmits data to it. In the process of receiving data from the sensor 8, the data is transmitted to a transceiver 9, which generates a signal from 300 to 450 MHz, and transmits the data at a rate of 100 to 50,000 bytes per hour via antenna 2, to a remote server via a low earth orbit satellite transponder. In the process of data transmission, a stable signal and stable data transmission rate from sensor 8 to the remote server under any weather or terrain conditions are observed, and the geography of seamlessly organised power line condition monitoring is expanded by more than 50%.

The device allows to receive data on the status of power lines from any geographical location, in remote areas, without coverage of GSM and other terrestrial communication networks, and without the need to monitor and evaluate GSM signal levels. This simplifies the choice of device installation location by eliminating the need to assess terrain conditions and possible weather conditions that may interfere with data transmission.

When changing the configuration of the equipment, in particular, when using a parabolic satellite antenna and installing a transceiver on frequencies up to 290 and above 455 MHz, there is signal degradation and packet loss with data received from the sensor 8 when monitoring the state of the PTL located in mountainous terrain under unfavourable weather conditions, in particular when snowfall.

Thus, the achievement of technical result is provided, consisting in increasing the stability of the two-way communication signal of the transceiver with low-orbit satellite repeaters, thereby improving the performance characteristics of the power transmission line condition monitoring device.

## Claims

1. The device for monitoring the state of a power line, containing a means for mounting on the power line, electrically connected: power supply, wireless communication module consisting of a transceiver and an antenna, and providing two-way communication via low-orbit satellite repeaters, control controller and interface for connection of the power line status sensor, differing in that the transceiver provides two-way communication via low-orbit satellite repeaters at frequencies from 300 to 450 MHz, with the antenna providing a 360° horizontal radiation pattern width.

2. A device according to claim 1, **characterized in that** the transceiver provides data transmission at a speed of 100 to 50,000 bytes per hour.

3. The device according to claim 1, **characterized in that** the antenna is made of a spiral or in the form of a flat lattice.

4. The device according to claim 1, **characterized in that** the power source is in the form of a supercapacitor.

5. The device according to claim 1, **characterized in that** the interface for connecting the power transmission line condition monitoring device can be USART or USB.
